# EUROPEAN PATENT APPLICATION

(11) **EP 2 674 518 A1**
(43) Date of publication of application: **18.12.2013**
(21) Application number: 13171673.0
(22) Date of filing: 12.06.2013
(51) Int. Cl.: C30B 29/40, C30B 25/02, C30B 25/16, H01L 21/02

(54) **Method of manufacturing gallium nitride substrate and gallium nitride substrate manufactured thereby**

(30) Priority: 12.06.2012 KR 20120062737
(71) Applicant: Samsung Corning Precision Materials Co., Ltd., Gyeongsangbuk-do Gumi-si, 730-735 (KR)
(72) Inventor: Lim, SungKeun, 336-841 Asan-si ChungCheongNam-Do (KR); Park, Boik, 336-841 Asan-si ChungCheongNam-Do (KR); Park, CheolMin, 336-841 Asan-si ChungCheongNam-Do (KR); Lee, DongYong, 336-841 Asan-si ChungCheongNam-Do (KR); Kim, Woorihan, 336-841 Asan-si ChungCheongNam-Do (KR); Kim, Joon Hoi, 336-841 Asan-si ChungCheongNam-Do (KR); Bae, JunYoung, 336-841 Asan-si ChungCheongNam-Do (KR); Lee, WonJo, 336-841 Asan-si ChungCheongNam-Do (KR); Choi, JunSung, 336-841 Asan-si ChungCheongNam-Do (KR)
(74) Representative: Gulde Hengelhaupt Ziebig & Schneider

(57) **Abstract**

A method of manufacturing a gallium nitride (GaN) substrate and a GaN substrate manufactured thereby. The method includes the steps of growing an aluminum nitride nucleation layer on a base substrate, growing a first gallium nitride film on the base substrate on which the aluminum nitride nucleation layer has been grown, the first gallium nitride film having a first content ratio of nitrogen to gallium, and growing a second gallium nitride film on the first gallium nitride film, the second gallium nitride film having a second content ratio of nitrogen to gallium which is lower than the first content ratio. Self-separation between the base substrate and the GaN substrate is possible during the growth process, thereby precluding mechanical separation, increasing a self-separation area, and minimizing the occurrence of warping.

## Description

### CROSS REFERENCE TO RELATED APPLICATION

The present application claims priority from Korean Patent Application Number 10-2012-0062737 filed on June 12, 2012, the entire contents of which application are incorporated herein for all purposes by this reference.

### BACKGROUND OF THE INVENTION

### Field of the Invention

The present invention relates to a method of manufacturing a gallium nitride (GaN) substrate and a GaN substrate manufactured thereby, and more particularly, to a method of manufacturing a GaN substrate and a GaN substrate manufactured thereby, in which self-separation between a base substrate and a GaN substrate is possible during a growth process, thereby precluding mechanical separation, increasing a self-separation area, and minimizing the occurrence of warping.

### Description of Related Art

GaN is a direct transition semiconductor material having a band gap energy of 3.39 eV, and is available for the fabrication of a light-emitting device (LED) that emits light in a short wavelength range. However, it is difficult to mass-produce GaN single crystals, since a high temperature of 1,500 °C or higher and a nitrogen atmosphere of 20,000 atms are required for growing liquid crystals due to a high nitrogen vapor pressure at a melting point. In addition, it is difficult to manufacture GaN by liquid phase epitaxy (LPE), since a thin panel type crystal having a size of about 100 mm² is currently available.

Accordingly, a GaN film or substrate was grown on a heterogeneous substrate using a vapor phase growth method, such as metal organic chemical vapor deposition (MOCVD) or hydride vapor phase epitaxy (HVPE). Here, MOCVD is not applicable to the manufacture of a GaN substrate having a thickness of tens to hundreds of micrometers because of a very slow growth rate thereof even though MOCVD can produce a high-quality film. For this reason, HVPE is mainly used for the manufacture of a GaN thin film since high-speed growth is possible in HVPE.

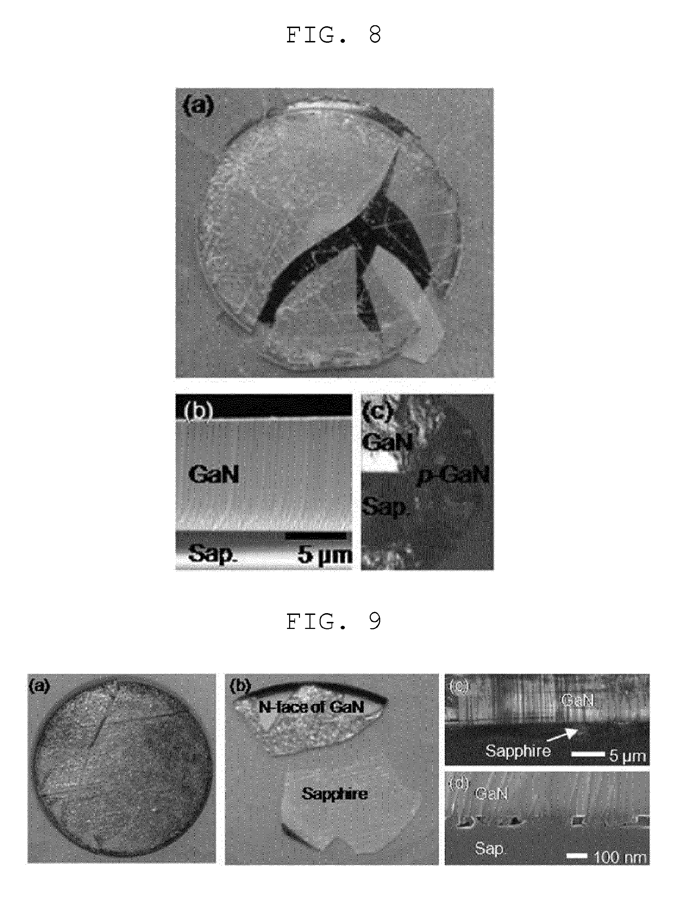

In addition, a sapphire substrate is most popular as a base substrate that is used for the manufacture of a GaN substrate because it has a hexagonal system like GaN, is inexpensive, and is stable at high temperatures. However, a difference (about 16%) in the lattice constant and a difference (about 35%) in the coefficient of thermal expansion between the sapphire and the GaN induce a strain at the interface between the sapphire and the GaN, which in turn creates lattice defects, warping and cracks in the crystal. This consequently makes it difficult to grow a high-quality GaN substrate, and furthermore, decreases the longevity of devices fabricated on the GaN substrate. In addition, in the GaN separation process, holes are formed in the surface of the sapphire during AlN nucleation for the GaN growth, thereby forming voids at the interface between the GaN and the sapphire. In this case, due to the maximum tensile stress acting on this interface, horizontal cracks are formed at the interface and propagate therefrom. The horizontal cracks then form vertical cracks while passing through voids. As a result, as shown in FIG. 9, self-separation partially occurs, which is problematic. Here, the part (a) in FIG. 9 is a picture of GaN grown on a sapphire substrate, in which a GaN film is self-separated due to horizontal cracks and is also broken into pieces due to vertical cracks. In addition, the part (b) in FIG. 9 is a picture of the pieces of the GaN film and the sapphire substrate taken using an optical microscope (OM), in which the GaN film and the sapphire substrate are separated from each other, but a portion of the sapphire being still attached to the GaN film. The part (c) in FIG. 9 is a picture of the cross-section of the part (a) taken using a scanning electron microscope (SEM), in which voids are formed between the GaN film and the sapphire substrate. It can be appreciated from the part (c) in FIG. 9 that the direction of the cracks is converted at the interface, thereby inducing the vertical cracks.

The information disclosed in the Background of the Invention section is provided only for better understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a method of manufacturing a gallium nitride (GaN) substrate and a GaN substrate manufactured thereby, in which self-separation between a base substrate and a GaN substrate is possible during a growth process, thereby precluding mechanical separation, increasing a self-separation area, and minimizing the occurrence of warping.

In an aspect of the present invention, provided is a method of manufacturing a gallium nitride substrate. The method includes the following steps of: growing an aluminum nitride nucleation layer on a base substrate; growing a first gallium nitride film on the base substrate on which the aluminum nitride nucleation layer has been grown, the first gallium nitride film having a first content ratio of nitrogen to gallium; and growing a second gallium nitride film on the first gallium nitride film, the second gallium nitride film having a second content ratio of nitrogen to gallium which, by atomic percent, is lower than the first content ratio.

According to an embodiment of the present invention, the first content ratio may range, by atomic percent, from 4:1 to 40:1, and the second content ratio may range, by atomic percent, from 1:1 to 2:1.

The step of growing the first gallium nitride film may grow the first gallium nitride film to a thickness ranging from 10 µm to 50 µm. Preferably, the first gallium nitride film is formed such to have a uniform thickness.

The step of growing the second gallium nitride film may grow the second gallium nitride film at a higher temperature than the first gallium nitride film.

The step of growing the second gallium nitride film may grow the second gallium nitride film at a temperature of 970 °C or higher.

The step of growing the second gallium nitride film may grow the second gallium nitride film at a slower growth rate than the first gallium nitride film.

The step of growing the second gallium nitride film may grow continuously growing the second gallium nitride film after horizontal cracks are formed in the first gallium nitride film while the second gallium nitride film is being grown.

The step of growing the second gallium nitride film may grow the second gallium nitride film to a thickness of 500 µm or greater. Preferably, the second gallium nitride film is formed such to have a uniform thickness.

The step of growing the first gallium nitride film may grow the first gallium nitride film via hydride vapor phase epitaxy, and/or growing the second gallium nitride film comprises growing the second gallium nitride film via hydride vapor phase epitaxy.

In addition, the base substrate may be implemented as a sapphire substrate. Preferably, the base substrate comprises sapphire; more preferably, the base substrate consists of sapphire.

In an aspect of the present invention, provided is a gallium nitride substrate that includes a first gallium nitride film, the content ratio of nitrogen to gallium of the first gallium nitride film ranging from 4:1 to 40:1; and a second gallium nitride film layered on the first gallium nitride film, the thickness of the second gallium nitride film being greater than the thickness of the first gallium nitride film, the content ratio of nitrogen to gallium of the second gallium nitride film ranging from 1:1 to 2:1. The thickness of the resulting first gallium nitride film (after self-separation from the base substrate) is lower than 50 µm, more preferably the thickness of the first gallium nitride film is lower than 30 µm. The thickness of the resulting second gallium nitride film (after self-separation from the base substrate) is greater than 500 µm. Preferably, the first gallium nitride film and the second gallium nitride film are both formed such to have a uniform thickness, respectively.

According to embodiments of the present invention, it is possible to coat the base substrate with the GaN film having a different microscopic structure so that the positions where horizontal cracks occur are more distanced from the interface between the GaN film and the base substrate, thereby preventing vertical cracks from being formed due to voids, enabling self-separation, and increasing the area which is to be self-separated.

In addition, it is possible to self-separate the GaN film from the base substrate without an additional process, for example, using a laser. It is therefore possible to increase yield, decrease a process time, and decrease a cost, thereby guaranteeing the cost competitiveness of a product.

Furthermore, while the GaN film is being continuously grown at one side, the GaN film is separated from the base substrate at the other side. This can consequently minimize the warping of or cracks in the GaN film, i.e. the GaN substrate, which is separated due to the difference in the coefficient of thermal expansion between the base substrate and the GaN film. Accordingly, it is possible to increase the yield of manufacture and produce a high-quality GaN substrate.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a process flowchart showing a method of manufacturing a GaN substrate according to an embodiment of the present invention;

FIG. 2 to FIG. 7 are cross-sectional views sequentially showing process steps of the method of manufacturing a GaN substrate according to an embodiment of the present invention;

FIG. 8 is a view showing images of a self-separated GaN substrate manufactured by the method of manufacturing a GaN substrate according to an embodiment of the present invention; and

FIG. 9 is a view showing images of a GaN substrate manufactured by a related art method.

### DETAILED DESCRIPTION OF THE INVENTION

Reference will now be made in detail to a method of manufacturing a gallium nitride (GaN) substrate and a GaN substrate manufactured thereby according to the present invention, embodiments of which are illustrated in the accompanying drawings and described below, so that a person having ordinary skill in the art to which the present invention relates can easily put the present invention into practice.

Throughout this document, reference should be made to the drawings, in which the same reference numerals and signs are used throughout the different drawings to designate the same or similar components. In the following description of the present invention, detailed descriptions of known functions and components incorporated herein will be omitted when they may make the subject matter of the present invention unclear.

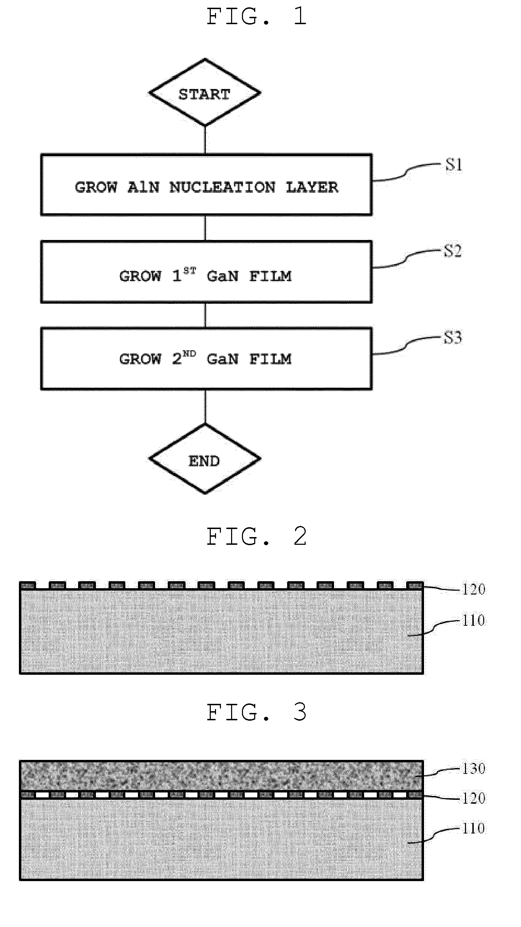

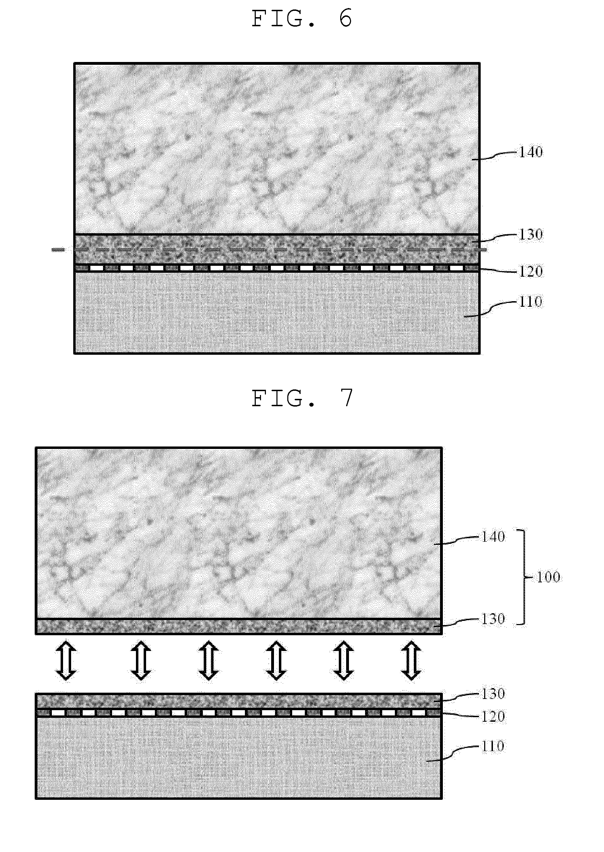

As shown in FIG. 1, the method of manufacturing a GaN substrate according to an embodiment of the present invention is a method of manufacturing a freestanding GaN substrate (100 in FIG. 7) used as a substrate for light-emitting devices (LEDs) and electronic devices, and includes an AlN nucleation layer growing step S1, a first GaN film growing step S2, and a second GaN film growing step S3.

First, as shown in FIG. 2, the AlN nucleation layer growing step S1 is the step of growing an AlN nucleation layer 120 on a base substrate 110. At this step, the AlN nucleation layer 120 can be grown on the base substrate 110 via vapor deposition using a NH₃ gas and a HCl gas. Here, since a sapphire substrate is used as the base substrate 110, an Al source gas can be omitted. As shown in the figure, the AlN nucleation layer 120 is grown on the base substrate 110 via vapor deposition, and has the shape of dots. Said dots are preferably arranged in a regular pattern on the base substrate 110, more preferably in a regular matrix-shaped pattern.

In addition, as shown in FIG. 3, the first GaN film growing step S2 is the step of growing a first GaN film 130 on the upper surface of the base substrate 110 on which the AlN nucleation layer 120 has been grown. At this step, the first GaN film 130 is grown on the upper surface of the base substrate 110 via vapor phase epitaxy, such as hydride vapor phase epitaxy (HVPE). Specifically, vapor deposition is conducted by loading the base substrate 110 into a growth furnace, blowing a GaCl gas and a NH₃ gas into the furnace, and heating the furnace such that the gases form a deposit. Here, it is preferred that the first GaN film 130 be grown at a temperature lower than a temperature at which the second GaN film 140 is to be grown in the subsequent process, for example, at a temperature lower than 970 °C, and at a rate faster than a rate at which the second GaN film 140 is to be grown.

In addition, at the first GaN film growing step S2, the first GaN film 130 is grown by controlling the content ratio, by atomic percent, of N to Ga in the gases supplied for the growth of the first GaN film 130 to be within the range from 4:1 to 40:1. In this fashion, when the content ratio of N to Ga in the first GaN film 130 is controlled within the range from 4:1 to 40:1, a plurality of pits which relieve a stress is formed inside the first GaN film 130. The pits formed inside the first GaN film 130 have the shape of, for example, an inverted pyramid, and the number of the pits is 100 per cm² or greater depending on the control over the content ratio as described above. According to this structure, the density of the pits is higher than that of pits of the second GaN film 140 which are to be formed in the subsequent process. The first GaN film 130 having the pits which are formed at a high density in this fashion makes it possible for the GaN substrate (100 in FIG. 7) to be self-separated during the process of growing the second GaN film 140. In other words, the first GaN film 130 acts as a separation interface film in the process of separating the GaN substrate (100 in FIG. 7).

In addition, since the pits are formed by controlling the content ratio of N to Ga inside the first GaN film 130, the positions where horizontal cracks are formed by a stress induced by the difference in the lattice constant between the base substrate 110 and the first GaN film 130 having different compositions can be more distanced from the interface between the base substrate 110 and the first GaN film 130. This can consequently prevent the vertical cracks of the related art from being induced by voids that are formed by the dot-type AlN nucleation layer 120, thereby increasing the area which is to be self-separated.

At the first GaN film growing step S2, it is preferred that the first GaN film 130 be grown to a thickness ranging from 10 to 50 µm. This is because, when the first GaN film 130 is formed at a thickness smaller than 10 µm, the pits formed inside the first GaN film 130 may be too close to the interface between the base substrate 110 and the first GaN film 130, thereby forming vertical cracks. When the first GaN film 130 is formed thicker than 50 µm, self-separation due to horizontal cracks may not occur.

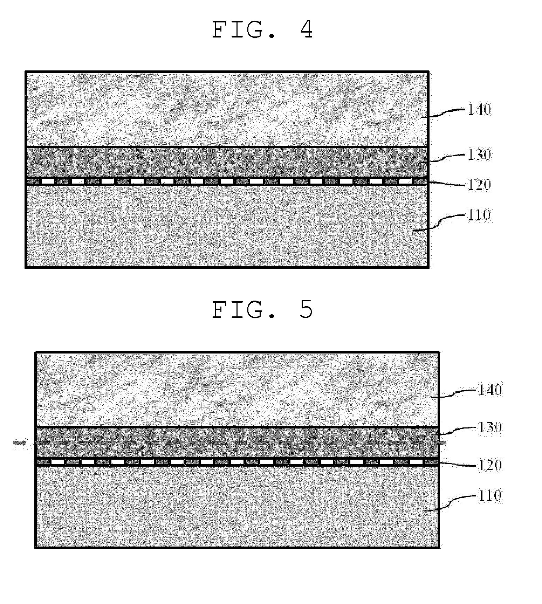

In subsequence, as shown in FIG. 4, the second GaN film growing step S3 is the step of growing the second GaN film 140 on the first GaN film 130. At this step, like the method of growing the first GaN film 130, the second GaN film 140 is grown on the first GaN film 130 via vapor phase epitaxy, such as HVPE. The second GaN film 140 is grown with a microscopic structure different from that of the first GaN film 130. That is, the microscopic structure of second GaN film 140 has superior crystallinity unlike that of the first GaN film 130. For this, the temperature at which the second GaN film 140 is grown is higher than the temperature at which the first GaN film 130 is grown. For instance, the second GaN film 140 is grown a temperature of 970 °C or higher. In addition, the growth rate of the second GaN film 140 is slower than the growth rate of the first GaN film 130.

In addition, at the second GaN film growing step S3, the second GaN film 140 is grown by controlling the content ratio, by atomic percent, of N to Ga in the gases supplied for the growth of the second GaN film 140 to be within the range from 1:1 to 2:1. In this fashion, when the content ratio of N to Ga in the second GaN film 140 is controlled within the range from 1:1 to 2:1, the second GaN film 140 has superior crystallinity unlike the first GaN film 130. Here, the pits formed inside the second GaN film 140 have the shape of, for example, an inverted pyramid, and the number of the pits is less than 100 per cm² depending on the control over the content ratio as described above.

In the meantime, when the second GaN film 140 is grown at the second GaN film growing step S3, horizontal cracks (indicated with a dotted line in FIG. 5) are induced by a stress inside the first GaN film 130 while the second GaN film 140 is being grown, as shown in FIG. 5. The horizontal cracks (indicated with the dotted line in FIG. 5) propagate in the horizontal direction.

As shown in FIG. 6, at the second GaN film growing step S3, the second GaN film 140 is continuously grown after the horizontal cracks are formed inside the first GaN film 130. For instance, at the second GaN film growing step S3, the second GaN film 140 can be grown to a thickness of 500 µm or greater. In this fashion, when the second GaN film 140 is continuously grown after the horizontal cracks are formed inside the first GaN film 130 so that the thick second GaN film 140 is formed on the first GaN film 130, it is possible to minimize warping of the first GaN film 130 and the second GaN film 140. When the warping is minimized in this fashion, it is possible to increase the yield of manufacture of the GaN substrate (100 in FIG. 7). Accordingly, high-quality GaN substrates can be produced.

In addition, as shown in FIG. 7, the first GaN substrate 130 is self-separated by the horizontal cracks formed in the first GaN film 130 before or after the completion of the growth of the second GaN film 140. This consequently completes the self-separation process of the GaN substrate 100 which is a stacked structure in which the second GaN film 140 is layered on the separated first GaN film 130. When the GaN substrate 100 is self-separated from the base substrate 110, it is possible to increase the yield of a product, omit a separate mechanical separation process, thereby decreasing a process time, and finally decrease a manufacturing cost, thereby acquiring the price competitiveness of the product.

FIG. 8 is a view showing images of a self-separated GaN substrate manufactured by the method of manufacturing a GaN substrate according to an embodiment of the present invention. The part (a) in FIG. 8 is a picture of the separated GaN substrate and a sapphire substrate, the part (b) in FIG. 8 is a picture of the cross-section of the separated sapphire substrate taken using a scanning electron microscope (SEM), and the part (c) of FIG. 8 is a picture of the cross-section of an edge part taken using the SEM. As shown in FIG. 8, it can be appreciated that the GaN and the sapphire are attached to each other at the edge part but are separated from each other at the other parts. Comparing the GaN substrate shown in FIG. 8 with the GaN substrate having the vertical cracks shown in FIG. 9, it can be appreciated that the separation area is increased when the GaN substrate is manufactured by the method of manufacturing a GaN substrate according to an embodiment of the present invention.

In addition, the base substrate 110 from which the GaN substrate 110 can be reused in growth and separation processes for a new GaN substrate.

The foregoing descriptions of specific exemplary embodiments of the present invention have been presented with respect to the drawings. They are not intended to be exhaustive or to limit the present invention to the precise forms disclosed, and obviously many modifications and variations are possible for a person having ordinary skill in the art in light of the above teachings.

It is intended therefore that the scope of the present invention not be limited to the foregoing embodiments, but be defined by the Claims appended hereto and their equivalents.

## Claims

1. A method of manufacturing a gallium nitride substrate (100, Fig. 7), comprising:
growing (S1) an aluminum nitride nucleation layer (120) on a base substrate (110);
growing (S2) a first gallium nitride film (130) on the base substrate (110) on which the aluminum nitride nucleation layer (120) has been grown, the first gallium nitride film (130) having a first content ratio of nitrogen to gallium; and
growing (S3) a second gallium nitride film (140) on the first gallium nitride film (130), the second gallium nitride film (140) having a second content ratio of nitrogen to gallium which is lower than the first content ratio.

2. The method of claim 1, wherein the first content ratio ranges, by atomic percent, from 4:1 to 40:1, and the second content ratio ranges, by atomic percent, from 1:1 to 2:1.

3. The method according to any one of the preceding claims, wherein growing the second gallium nitride film (140) comprises growing the second gallium nitride film (140) at a slower growth rate than the first gallium nitride film (130).

4. The method according to any one of the preceding claims, wherein growing the second gallium nitride film (140) comprises growing the second gallium nitride film (140) at a higher temperature than the first gallium nitride film (130).

5. The method of claim 4, wherein growing the second gallium nitride film (140) comprises growing the second gallium nitride film (140) at a temperature of 970 °C or higher.

6. The method according to any one of the preceding claims, wherein growing the first gallium nitride film (130) comprises growing the first gallium nitride film (130) to a thickness ranging from 10 µm to 50 µm.

7. The method according to any one of the preceding claims, wherein growing the second gallium nitride film (140) comprises continuously growing the second gallium nitride film (140) after horizontal cracks are formed in the first gallium nitride film (130) while the second gallium nitride film (140) is being grown.

8. The method according to any one of the preceding claims, each of the first gallium nitride film (130) and the second gallium nitride film (140) are grown with a continuous growth rate, respectively.

9. The method according to any one of the preceding claims, wherein growing the second gallium nitride film (140) comprises growing the second gallium nitride film (140) to a thickness of 500 µm or greater.

10. The method according to any one of the preceding claims, wherein growing the first gallium nitride film (130) comprises growing the first gallium nitride film (130) via hydride vapor phase epitaxy, and growing the second gallium nitride film (140) comprises growing the second gallium nitride film (140) via hydride vapor phase epitaxy.

11. The method according to any one of the preceding claims, wherein the base substrate (110) comprises sapphire.

12. The method according to any one of the preceding claims, wherein the second gallium nitride film (140) and at least a part of the first gallium nitride film (130) are self-separated from the base substrate (110) without an additional separation process.

13. A gallium nitride substrate (100) comprising:
a first gallium nitride film (130), a content ratio of nitrogen to gallium of the first gallium nitride film (130) ranging from 4:1 to 40:1; and
a second gallium nitride film (140) layered on the first gallium nitride film (130), a thickness of the second gallium nitride film (140) being greater than a thickness of the first gallium nitride film (130), a content ratio of nitrogen to gallium of the second gallium nitride film (140) ranging from 1:1 to 2:1.

14. The gallium nitride substrate (100) of claim 13, wherein the thickness of the first gallium nitride film (130) is lower than 50 µm.

15. The gallium nitride substrate (100) according to any of claims 13 and 14, wherein the thickness of the second gallium nitride film (140) is greater than 500 µm.
